# EUROPÄISCHE PATENTSCHRIFT

(11) **EP 0 582 584 B1**
(45) Veröffentlichungstag und Bekanntmachung des Hinweises auf die Patenterteilung: **19.03.1997**
(21) Anmeldenummer: 92907377.3
(22) Anmeldetag: 03.04.1992
(51) Int. Cl.: G06F 3/05, G08C 15/06, H03M 1/12, H04J 3/04

(54) **SCHALTUNGSANORDNUNG ZUM WANDELN MEHRERER AN EINGANGSANSCHLÜSSEN LIEGENDER, ANALOGER ELEKTRISCHER MESSIGNALE IN ENTSPRECHENDE DIGITALE SIGNALE**
CIRCUIT ARRANGEMENT FOR CONVERTING A PLURALITY OF ANALOG ELECTRICAL MEASUREMENT SIGNALS APPLIED TO INPUT TERMINALS TO CORRESPONDING DIGITAL SIGNALS
AGENCEMENT DE CIRCUITS POUR LA CONVERSION DE PLUSIEURS SIGNAUX ELECTRIQUES ANALOGIQUES DE MESURE APPLIQUES A DES BORNES D'ENTREE EN SIGNAUX NUMERIQUES CORRESPONDANTS

(30) Priorität: 03.05.1991 DE 4114971
(43) Veröffentlichungstag der Anmeldung: 16.02.1994
(73) Patentinhaber: SIEMENS AKTIENGESELLSCHAFT, 80333 München (DE)
(72) Erfinder: SEZI, Tevfik, Dr., D-12169 Berlin (DE)
(86) Internationale Anmeldenummer: DE9200279
(87) Internationale Veröffentlichungsnummer: WO9220025

(56) Entgegenhaltungen:
- EP-A- 0 351 788
- EP-A- 0 372 526
- IBM TECHNICAL DISCLOSURE BULLETIN. Bd. 23, Nr. 9, Februar 1981, NEW YORK US
- Seiten 4210 - 4213; ZUMBADO: 'Data acquisition system architecture with dedicated sample holds'

## Beschreibung

Es ist eine Schaltungsanordnung zum Wandeln mehrerer an Eingangsanschlüssen liegender, analoger elektrischer Meßsignale in entsprechende digitale Signale dadurch bekannt geworden, daß sie im Rahmen des Siemens-Hochspannungsschutzes 7 SA 502 offenkundig vorbenutzt worden ist. Bei diesem Gerät werden mittels der Schaltungsanordnung mehrere analoge elektrische Meßsignale erfaßt und zur Ermittlung von fehlerhaften Netzzuständen nach Wandlung in digitale Signale miteinander verglichen.

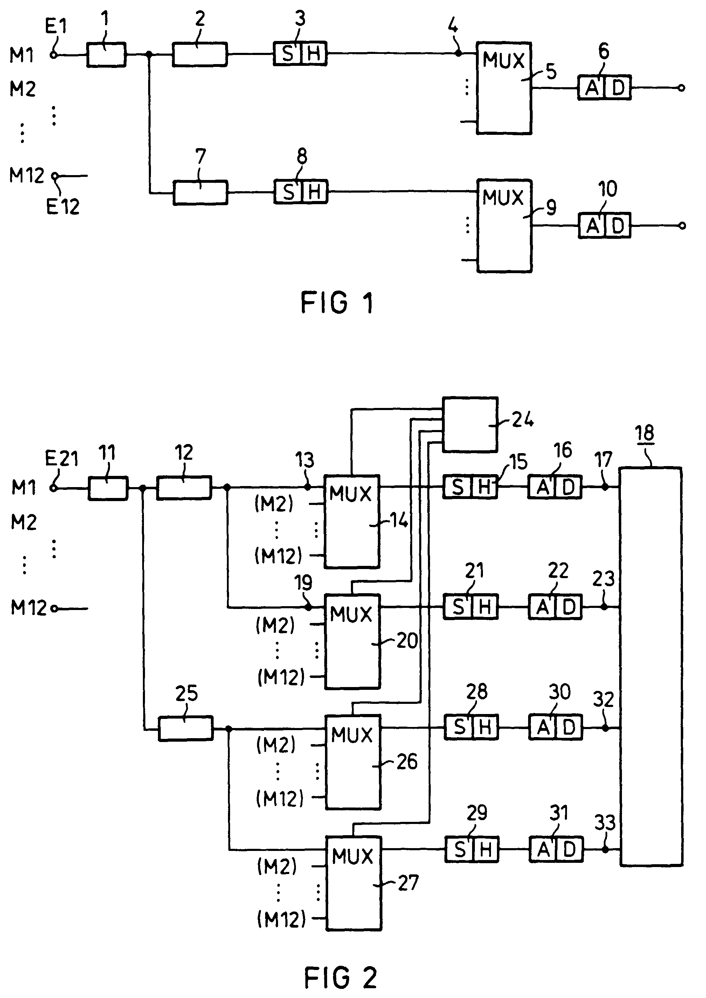

Die offenkundig vorbenutzte Schaltungsanordnung enthält eingangsseitig zu diesem Zwecke für jedes zu wandelnde, elektrische Meßsignal ein Antialiasing-Filter 1 (vgl. Figur 1), das mit seinem Eingang an einen Eingangsanschluß E1 für ein analoges elektrisches Meßsignal M1 angeschlossen ist. Es werden mit dem offenkundig vorbenutzten Gerät insgesamt zwölf analoge elektrische Meßsignale M1 bis M12 erfaßt, die jeweils an Eingangsanschlüssen E1 bis E12 angelegt sind. Da die den Eingangsanschlüssen nachgeordneten Eingangsteile des Gerätes gleich ausgebildet sind, ist im folgenden nur der Eingangsteil für das analoge elektrische Meßsignal M1 beschrieben. Dem oben bereits erwähnten Antialiasing-Filter 1 ist ein Verstärker 2 nachgeordnet, der eine Verstärkung V=1 besitzt. An diesen Verstärker 2 ist eine Abtast-Halte-Schaltung 3 angeschlossen, der mit einem Eingang 4 ein Multiplexer 5 nachgeordnet ist. Ausgangsseitig ist an den Multiplexer 5 ein Analog-Digital-Wandler 6 angeschlossen, dem eine in der Figur 1 nicht dargestellte Auswerteeinrichtung nachgeordnet ist.

Wie die Figur 1 ferner zeigt, ist dem Antialiasing-Filter 1 der bekannten Schaltungsanordnung ein weiterer Verstärker 7 nachgeordnet, der eine Verstärkung V=16 besitzt. Über eine weitere Abtast-Halte-Schaltung 8 ist an den weiteren Verstärker 7 ein weiterer Multiplexer 9 angeschlossen, dem ausgangsseitig ein weiterer Analog-Digital-Wandler 10 nachgeordnet ist. Ausgangsseitig ist dieser Wandler 10 ebenfalls mit der nicht dargestellten Auswerteeinrichtung verbunden. Die Verwendung des Auswerteweges mit dem Verstärker 2 ist vorgesehen, um auch bei Sättigung des Verstärkers 7 noch mit ausreichend hoher Genauigkeit arbeiten zu können.

Ebenso wie mit dem Eingangsanschluß E1 sind die Multiplexer 5 und 9 über zusätzliche Abtast-Halte-Schaltungen (nicht dargestellt) entsprechend den Schaltungen 3 und 8 sowie über ebenfalls nicht dargestellte Verstärker entsprechend den Verstärkern 2 und 7 sowie über jeweils ein Antialiasing -Filter entsprechend dem Filter 1 mit den weiteren Eingangsanschlüssen für die Meßgrößen M2 bis M12 verbunden.

Durch die Verwendung der Abtast-Halte-Schaltungen 3 und 8 für die verschiedenen analogen elektrischen Meßsignale M1 bis M12 ist sichergestellt, daß die verschiedenen analogen elektrischen Meßsignale zum jeweils selben Zeitpunkt erfaßt werden. Nach Abfrage durch die Multiplexer 5 und 9 und Wandlung in digitale Signale kann dann in der nicht dargestellten Auswerteeinrichtung aus einem Vergleich der den analogen elektrischen Meßsignalen entsprechenden digitalen Signale auf den Zustand des zu überwachenden Netzes geschlossen werden.

Eine ähnliche Schaltungsanordnung wie die in Figur 1 gezeigte ist in "IBM Technical Disclosure Bulletin", Vol. 33, No. 9, Febr. 1981, Seiten 4210 bis 4213 beschrieben. Darüber hinaus gibt diese Literaturstelle eine Schaltungsanordnung zum Wandeln mehrerer an Eingangsanschlüssen liegender, analoger Meßsignale in entsprechende digitale Signale an, bei der jedem von mehreren Multiplexern über Eingangsfilter mehrere Meßgrößen zugeführt werden. Ausgangsseitig ist an jeden Multiplexer eine Reihenschaltung aus einer Abtast-Halte-Schaltung mit nachgeordnetem Analog-Digital-Wandler angeschlossen.

Ferner ist aus der EP 0 372 526 A2 ein Mikrocomputer bekannt, der eine schnelle Analog-Digital-Wandlung ermöglicht. Bei dieser bekannten Anordnung sind mehrere Abtast-Halte-Schaltungen entweder an eine einzige Meßgröße oder an mehrere Meßgrößen angeschlossen; über Transfer-Torschaltungen, die aufgrund ihrer Ansteuerung als Multiplexer wirken, werden die abgetasteten Werte nacheinander einer Einrichtung zur Analog-Digital-Wandlung zugeführt.

Der Erfindung liegt die Aufgabe zugrunde, eine Schaltungsanordnung zum Wandeln mehrerer an Eingangsanschlüssen liegender, analoger elektrischer Meßsignale in entsprechende digitale Signale vorzuschlagen, die sich unter Verstärkung der Wirkung der Antialiasingfilter mit verhältnismäßig geringem Schaltungsaufwand verwirklichen läßt.

Zur Lösung dieser Aufgabe ist eine Schaltungsanordnung zum Wandeln mehrerer an Eingangsanschlüssen liegender, analoger elektrischer Meßsignale in entsprechende digitale Signale erfindungsgemäß versehen mit Antialiasing-Filtern, die jeweils mit ihrem Eingang an einen Eingangsanschluß und mit ihrem Ausgang an jeweils einen Eingang von mindestens zwei Multiplexern angeschlossen sind, mit mindestens zwei Abstand-Halte-Schaltungen, die jeweils mit ihrem Eingang an den Ausgang eines Multiplexers angeschlossen sind, mit mindestens zwei Analog-Digital-Wandlern, die jeweils mit ihrem Eingang an den Ausgang einer Abtast-Halte-Schaltung angeschlossen sind, mit einer Auswerteeinrichtung, die den mindestens zwei Analog-Digital-Wandlern nachgeordnet ist und die in einem Auswerteintervall mehreren Abtastwerten eines analogen elektrischen Signals entsprechende Digitalwerte ermittelt und durch Mittelwertbildung das entsprechende digitale Signal erzeugt, und mit einer mit den mindestens zwei Multiplexern verbundenen Steuereinrichtung, die die Multiplexer derart steuert, daß die Ausgänge der Antialiasing-Filter über den einen Multiplexer nacheinander in einer Reihenfolge und gleichzeitig die Ausgänge der Antialiasing-Filter über den zweiten Multiplexer nacheinander in einer dazu umgekehrten Reihenfolge mit den Abtast-Halte-Schaltungen verbunden werden.

Der wesentliche Vorteil der erfindungsgemäßen Schaltungsanordnung besteht darin, daß sie im Vergleich zu dem bekannten Gerät zum Wandeln von relativ vielen analogen elektrischen Meßsignale in digitale Signale mit zwei Multiplexern und zwei Abtast-Halte-Schaltungen auskommt, wenn in einem Grundaufbau nur ein Auswerteweg für jedes analoge elektrische Meßsignal vorgesehen ist. Sind - wie bei dem oben behandelten, offenkundig vorbenutzten Gerät - zwei Auswertewege über zwei Verstärker mit unterschiedlicher Verstärkung vorgesehen, dann sind zur Wandlung sämtlicher analoger elektrischer Meßsignale insgesamt vier Multiplexer und vier Abtast-Halte-Schaltungen mit nachgeordneten Analog-Digital-Wandlern erforderlich. Dies bringt eine erhebliche Einsparung mit sich, weil bei der erfindungsgemäßen Schaltungsanordnung zur Wandlung sämtlicher analoger elektrischer Meßsignale nur doppelt so viele Halteschaltungen erforderlich sind, wie bei der bekannten Schaltungsanordnung für die Wandlung eines einzigen elektrischen Meßsignals. Dafür muß zwar eine doppelt so hohe Anzahl von Multiplexern verwendet werden, jedoch ist dieser Mehraufwand nicht sonderlich hoch.

Ein weiterer Vorteil der erfindungsgemäßen Schaltungsanordnung besteht darin, daß relativ einfach aufgebaute Antialiasing-Filter (ohne Verstärker) Verwendung finden können, weil die Mittelwertbildung die Wirkung einer zusätzlichen Dämpfung hat. Die einfach aufgebauten Antialiasing-Filter vermindern Offsetprobleme und ermöglichen einen einfachen Abgleich der Schaltungsanordnung.

Der Aufbau der erfindungsgemäßen Schaltungsanordnung beruht auf der Erkenntnis, daß durch die oben angegebene Steuerung der Multiplexer ein Abtastschema erreicht werden kann, das zu einem mittleren Zeitpunkt symmetrisch ist; durch Mittelwertbildung über jeweils die einem Meßsignal zugeordneten Digitalwerte und Erfassung zu diesem mittleren Zeitpunkt lassen sich den analogen elektrischen Meßsignalen entsprechende digitale Signale gewinnen, so daß über den Vergleich dieser digitalen Signale ein Vergleich der analogen elektrischen Meßsignale bezogen auf ein und denselben Meßzeitpunkt durchführbar ist, ohne daß verfälschende Phasenverschiebungen auftreten.

Bei einer vorteilhaften Ausführungsform der erfindungsgemäßen Schaltungsanordnung ist die Auswerteeinrichtung so ausgebildet, daß sie im entsprechend bemessenen Auswerteintervall jeweils zwei Abtastwerten eines analogen elektrischen Signals entsprechende Digitalwerte erfaßt und durch Mittelwertbildung das entsprechende digitale Signal erzeugt.

Besonders deutlich werden die oben angegebenen Vorteile der erfindungsgemäßen Schaltungsanordnung, wenn ihre Auswerteeinrichtung so ausgebildet ist, daß sie im entsprechend bemessenen Auswerteintervall jeweils vier Abtastwerten eines analogen elektrischen Signals entsprechende Digitalwerte erfaßt und durch Mittelwertbildung das entsprechende digitale Signal erzeugt. In diesem Falle kann bei Erzielung einer guten Dämpfung mit als RC-Glieder ausgebildeten Antialiasing-Filtern gearbeitet werden.

Als vorteilhaft wird es im Rahmen der vorliegenden Erfindung angesehen, wenn die erfindungsgemäße Schaltungsanordnung versehen ist mit vier Multiplexern, von denen zwei Multiplexer über einen Verstärker mit der Verstärkung 1 und zwei weitere Multiplexer über einen Verstärker mit erhöhter Verstärkung an die Antialiasing-Filter angeschlossen sind, mit vier den Multiplexern nachgeordneten Abtast-Halte-Schaltungen und mit vier den Abtast-Halte-Schaltungen nachgeordneten Analog-Digital-Wandlern, die mit ihren Ausgängen an die Auswerteeinrichtung angeschlossen sind. Damit läßt sich wie bei der offenkundig vorbenutzten Schaltungsanordnung die Genauigkeit auch für den Fall einhalten, daß der Verstärker mit erhöhter Verstärkung während der Messung in die Sättigung gerät.

Als Auswerteeinrichtung wird bei der erfindungsgemäßen Schaltungsanordnung vorteilhafterweise ein Signalprozessor eingesetzt.

Zur Erläuterung der Erfindung ist in
Figur 2 ein Ausführungsbeispiel der erfindungsgemäßen Schaltungsanordnung, in
Figur 3 ein Abtastschema für die einzelnen elektrischen Meßsignale und in
Figur 4 ein Abtastmuster für die einzelnen elektrischen Meßsignale angegeben.

Gemäß Figur 2 ist an einen Eingangsanschluß E21 mit seinem Eingang ein Antialiasing-Filter 11 angeschlossen, dem in einem Auswerteweg ein Verstärker 12 mit der Verstärkung V=1 nachgeordnet ist. An den Ausgang dieses Verstärkers 12 ist mit einem Eingang 13 ein Multiplexer 14 angeschlossen, dem ausgangsseitig eine Abtast-Halte-Schaltung 15 nachgeordnet ist. Ausgangsseitig ist an die Abtast-Halte-Schaltung 15 ein Analog-Digital-Wandler 16 angeschlossen, der ausgangsseitig mit einem Eingang 17 einer Auswerteeinrichtung 18 verbunden ist.

An den Ausgang des Verstärkers 12 ist mit einem Eingang 19 ein weiterer Multiplexer 20 angeschlossen, dem eine weitere Abtast-Halte-Schaltung 21 nachgeordnet ist. Diese Abtast-Halte-Schaltung 21 ist ausgangsseitig mit einem Analog-Digital-Wandler 22 verbunden, der ausgangsseitig an einem weiteren Eingang 23 der Auswerteeinrichtung 18 liegt.

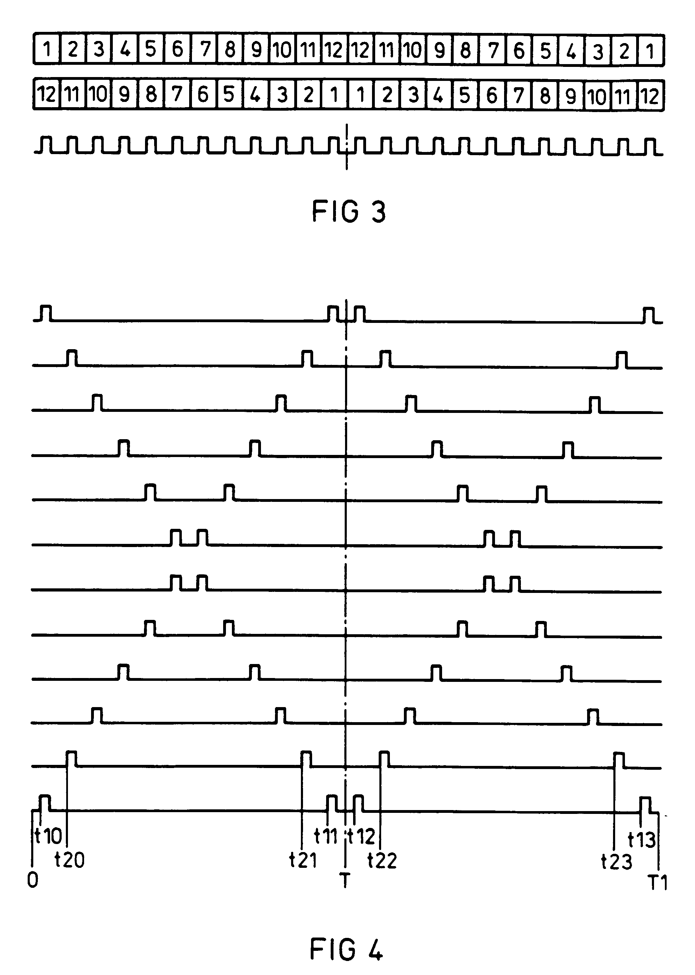

In ähnlicher Weise sind weitere Meßgrößen M2 bis M12 über jeweils ein Antialiasing-Filter entsprechend dem Filter 11 mit jeweils einem Verstärker entsprechend dem Verstärker 12 mit weiteren Eingängen der Multplexer 14 und 20 verbunden. Diese Multiplexer 14 und 20 werden durch eine Steuereinrichtung 24 so gesteuert, daß Ausschnitten aus den analogen elektrischen Meßgrößen M1 bis M12 entsprechend Abtastsignalen gemäß Zeile 3 der Figur 3 in einer Reihenfolge nacheinander auf die nachgeordneten Abtast-Halte-Schaltungen 15 bzw. 21 durchgeschaltet werden, wie dies aus den beiden oberen Zeilen der Figur 3 ersichtlich ist; in dieser Figur sind aus Platzgründen die verschiedenen Meßsignale nur durch ihre Kennziffern wiedergegeben.

Im einzelnen ist in der Figur 3 dargestellt, daß von dem Multiplexer 14 zunächst für die Dauer des ersten Abtastsignals gemäß der dritten Zeile in Figur 3 die Meßgröße M1 auf die Abtast-Halte-Schaltung 15 übertragen wird (vgl. Zeile 1 der Fig. 3). Gleichzeitig wird von dem Multiplexer 20 die Meßgröße M12 auf die Abtast-Halte-Schaltung 21 durchgeschaltet. Danach wird auf einen folgenden Abtastimpuls von dem Multiplexer 14 die Meßgröße M2 auf die Abtast-Halte-Schaltung 15 durchgeschaltet, während der Multiplexer 20 die Meßgröße M11 auf die Abtast-Halte-Schaltung 21 durchschaltet. Beide Multiplexer 14 bzw. 20 schalten also mit jedem Abtastimpuls die analogen elektrischen Meßsignale M1 bis M12 in zueinander umgekehrter Reihenfolge auf die nachgeordneten Halteschaltungen 15 bzw. 21 durch, wie dies die oberen Zeilen der Figur 3 ganz deutlich erkennen lassen.

Dies führt, wie Figur 4 zeigt, dazu, daß die Meßgröße M1 zum Zeitpunkt t10 sowie zu den Zeitpunkten t11, t12 und t13 erfaßt wird. Hinsichtlich der Meßgröße M2 ergibt sich im Zusammenhang mit der Figur 3, daß diese zu den Zeitpunkten t20, t21, t22 und t23 abgetastet wird. Entsprechendes gilt für die übrigen Meßgrößen M3 bis M12, so daß sich ein Abtastmuster ergibt, wie es die Figur 4 zeigt. Dieses Muster ist bezüglich des Zeitpunktes T symmetrisch. Führt man nun mit der Auswerteeinrichtung 18, die vorzugsweise als Signalprozessor ausgebildet ist, für jede abgetastete Meßgröße eine Mittelwertbildung über das Auswerteeintervall 0 bis T1 durch, dann ergeben sich aufgrund des Abtastmusters zum Zeitpunkt T1 (Ende des Auswerteintervalls) Mittelwerte, die den analogen elektrischen Meßsignalen entsprechen. Damit ist trotz der zeitlich aufeinanderfolgenden Abtastung der analogen, elektrischen Meßsignale ein übereinstimmender zeitlicher Bezugspunkt gewonnen, und es kann durch einen Vergleich der digitalen Signale untereinander auf Netzstörungen geschlossen werden.

Es ist auch möglich, daß Auswerteintervall in den Bereich von 0 bis T zu legen. Dann werden jeweils nur zwei aus jedem analogen Meßsignal gewonnene Digitalwerte zur Mittelwertbildung herangezogen.

An dem Ausgang des Antialiasing-Filters 11 ist bei dem Ausführungsbeispiel nach Figur 2 ein weiterer Verstärker 25 mit einer Verstärkung V=1b angeschlossen. Diesem Verstärker 25 sind zusätzliche Multiplexer 26 und 27 nachgeordnet, an deren Ausgänge Abtast-Halte-Schaltungen 28 und 29 angeschlossen sind.

Denen wieder ist jeweils ein zusätzlicher Analog-Digital-Wandler 30 und 31 nachgeordnet, die ausgangsseitig mit Eingängen 32 und 33 der Auswerteeinrichtung 18 verbunden sind. Das dem Verstärker 25 nachgeordnete Schaltungsteil arbeitet genau so wie der oben ausführlich behandelte Schaltungsteil mit den Multiplexern 14 und 20, so daß hier zur Vermeidung von Wiederholungen auf die Wirkungsweise nicht näher eingegangen zu werden braucht. Die beiden Schaltungsteile sind bei unterschiedlich hohen Meßsignalen M1 bis M12 wirksam.

## Patentansprüche

1. Schaltungsanordnung zum Wandeln mehrerer an Eingangsanschlüssen (E21) liegender, analoger elektrischer Meßsignale (M1 bis M12) in entsprechende digitale Signale mit
a) Antialiasing-Filtern (11), die
a1) jeweils mit ihrem Eingang an einen Eingangsanschluß (E21) und mit ihrem Ausgang an jeweils einen Eingang (13) von mindestens zwei Multiplexern (14,20;26,27) angeschlossen sind, mit
b) mindestens zwei Abtast-Halte-Schaltungen (15,21;28,29), die
b1) jeweils mit ihrem Eingang an den Ausgang eines Multiplexers (14,20;26,27) angeschlossen sind, mit
c) mindestens zwei Analog-Digital-Wandlern (16,22;30,31), die
c1) jeweils mit ihrem Eingang an den Ausgang einer Abtast-Halte-Schaltung (15,21;28,29) angeschlossen sind, mit
d) einer Auswerteeinrichtung (18), die
d1) den mindestens zwei Analog-Digital-Wandlern (16,22;30,31) nachgeordnet ist und die
d2) in einem Auswerteintervall (0 bis T1) mehreren Abtastwerten eines analogen elektrischen Signals (M1 bis M12) entsprechende Digitalwerte erfaßt und durch Mittelwertbildung das entsprechende digitale Signal erzeugt, und mit
e) einer mit den mindestens zwei Multiplexern (14,20;26,27) verbundenen Steuereinrichtung (24), die
e1) die Multiplexer (14,20;26,27) derart steuert, daß die Ausgänge der Antialiasing-Filter (11) über den einen Multiplexer (z.B. 14) nacheinander in einer Reihenfolge und gleichzeitig die Ausgänge der Antialiasing-Filter über den zweiten Multiplexer (z.B. 20) nacheinander in einer dazu umgekehrten Reihenfolge mit den Abtast-Halte-Schaltungen (z.B. 15,21) verbunden werden.

2. Schaltungsanordnung nach Anspruch 1 mit
f) einer derart ausgebildeten Auswerteeinrichtung (18), daß sie im entsprechend bemessenen Auswerteintervall jeweils zwei Abtastwerten eines analogen elektrischen Signals (M1 bis M12) entsprechende Digitalwerte erfaßt und durch Mittelwertbildung das entsprechende digitale Signal erzeugt.

3. Schaltungsanordnung nach Anspruch 1 mit
g) einer derart ausgebildeten Auswerteeinrichtung (18), daß sie im entsprechend bemessenen Auswerteintervall jeweils vier Abtastwerten eines analogen elektrischen Signals (M1 bis M12) entsprechende Digitalwerte erfaßt und durch Mittelwertbildung das entsprechende digitale Signal erzeugt.

4. Schaltungsanordnung nach einem der vorangehenden Ansprüche mit
h) vier Multiplexern (14,20;26,27), von denen zwei Multiplexer (14,20) über einen Verstärker (12) mit der Verstärkung Eins und zwei weitere Multiplexer (16,27) über einen Verstärker (25) mit erhöhter Verstärkung an die Antialiasing-Filter (11) angeschlossen sind, mit
i) vier den Multiplexern (14,20;26,27) nachgeordneten Abtast-Halte-Schaltungen (15,21;28,29) und mit
j) vier den Abtast-Halte-Schaltungen (15,21;28,29) nachgeordneten Analog-Digital-Wandlern (16,22;30,31), die
j1) mit ihren Ausgängen an die Auswerteeinrichtung (18) angeschlossen sind.

5. Schaltungsanordnung nach einem der vorangehenden Ansprüche mit
i) einem Signalprozessor als Auswerteeinrichtung (18).

## Claims

1. Circuit arrangement for converting a plurality of analog electrical measurement signals (M1 to M12) applied to input terminals (E21) to corresponding digital signals,
a) with antialiasing filters (11)
a1) the input of each of which is connected to an input terminal (E21) and the output of each of which is connected to an input (13) of each of at least two multiplexers (14, 20; 26, 27),
b) with at least two sample-and-hold circuits (15, 21; 28, 29),
b1) the input of each of which is connected to the output of a multiplexer (14, 20; 26, 27),
c) with at least two analog-to-digital converters (16, 22; 30, 31),
c1) the input of each of which is connected to the output of a sample-and-hold circuit (15, 21; 28, 29),
d) with an evaluating device (18),
d1) which is connected on the output side of the at least two analog-to-digital converters (16, 22; 30, 31)
d2) and which, in an evaluation interval (0 to T1), acquires digital values corresponding to several sampling values of an analog electrical signal (M1 to M12) and generates the corresponding digital signal through mean-value generation,
e) and with a control device (24), connected to the at least two multiplexers (14, 20; 26, 27),
e1) which controls the multiplexers (14, 20; 26, 27) in such a way that the outputs of the antialiasing filters (11) through the one multiplexer (e.g. 14) are connected successively to the sample-and-hold circuits (e.g. 15, 21) in one sequence and, simultaneously, the outputs of the antialiasing filters through the second multiplexer (e.g. 20) are so connected in an inverse sequence.

2. Circuit arrangement according to Claim 1,
f) with an evaluating device (18) which is designed so that in the appropriately calculated evaluation interval it acquires digital values corresponding in each case to two sampling values of an analog electrical signal (M1 to M12) and generates the corresponding digital signal by mean-value generation.

3. Circuit arrangement according to Claim 1,
g) with an evaluating device (18) which is designed so that in the appropriately calculated evaluation interval it acquires digital values corresponding in each case to four sampling values of an analog electrical signal (M1 to M12) and generates the corresponding digital signal by mean-value generation.

4. Circuit arrangement according to any one of the preceding Claims,
h) with four multiplexers (14, 20; 26; 27) of which two multiplexers (14, 20) are connected to the antialiasing filters (11) through an amplifier (12) having the amplification 1 and two further multiplexers (16, 27) are so connected through an amplifier (25) having a higher amplification,
i) with four sample-and-hold circuits (15, 21; 28, 29) connected on the output side of the multiplexers (14, 20,; 26, 27),
j) and with four analog-to-digital converters (16, 22; 30, 31), connected on the output side of the sample-and-hold circuits (15, 21; 28, 29),
j1) whose outputs are connected to the evaluating device (18).

5. Circuit arrangement according to any one of the preceding claims,
k) with a signal processor as the evaluating device (18).

## Revendications

1. Montage pour la conversion de plusieurs signaux électriques analogiques de mesure (M1 à M12) appliqués à des bornes d'entrée (E21) en signaux numériques correspondants, comportant
a) des filtres antirepliement (11),
a1) qui sont raccordés chacun par leur entrée à une borne d'entrée (E21) et par leur sortie à une entrée (13) d'au moins deux multiplexeurs (14, 20; 26, 27),
b) au moins deux circuits d'échantillonnage et de maintien (15, 21 ; 28, 29),
b1) qui sont raccordés chacun par leur entrée à la sortie d'un multiplexeur (14, 20 ; 26, 27),
c) au moins deux convertisseurs analogique-numérique (16, 22 ; 30, 31),
c1) qui sont raccordés chacun par leur entrée à la sortie d'un circuit d'échantillonnage et de maintien (15, 21; 28, 29),
d) un dispositif d'évaluation (18),
d1) qui est branché en aval des au moins deux convertisseurs analogique-numérique (16, 22 ; 30, 31) et
d2) qui, dans un intervalle d'évaluation (0 à T1), acquiert des valeurs numériques correspondant à plusieurs valeurs échantillonnées d'un signal électrique analogique (M1 à M12) et produit le signal numérique correspondant en formant une moyenne,
e) et un dispositif de commande (24) relié aux au moins deux multiplexeurs (14, 20 ; 26, 27),
e1) qui commande les multiplexeurs (14, 20; 26, 27) de telle sorte que les sorties des filtres antirepliement (11) soient reliées aux circuits d'échantillonnage et de maintien (par exemple 15, 21) par l'intermédiaire d'un premier multiplexeur (par exemple 14) successivement dans un certain ordre et, en même temps, les sorties des filtres antirepliement (11) soient reliées aux circuits d'échantillonnage et de maintien (par exemple 15, 21) par l'intermédiaire du second multiplexeur (par exemple 20) successivement dans un ordre inverse du précédent.

2. Montage selon la revendication 1, comportant
f) un dispositif d'évaluation (18) conçu de telle sorte que, dans l'intervalle d'évaluation dimensionné en conséquence, il acquiert des valeurs numériques correspondant à deux valeurs échantillonnées d'un signal électrique analogique (M1 à M12) et il produit le signal numérique correspondant en formant une moyenne.

3. Montage selon la revendication 1, comportant
g) un dispositif d'évaluation (18) conçu de telle sorte que, dans l'intervalle d'évaluation dimensionné en conséquence, il acquiert des valeurs numériques correspondant à quatre valeurs échantillonnées d'un signal électrique analogique (M1 à M12) et il produit le signal numérique correspondant en formant une moyenne.

4. Montage selon l'une des revendications précédentes, comportant
h) quatre multiplexeurs (14, 20 ; 26, 27), parmi lesquels deux multiplexeurs (14, 20) sont raccordés aux filtres antirepliement (11) par l'intermédiaire d'un amplificateur (12) de gain un et deux autres multiplexeurs (16, 27) sont raccordés aux filtres antirepliement (11) par l'intermédiaire d'un amplificateur (25) de gain supérieur,
i) quatre circuits d'échantillonnage et de maintien (15, 21 ; 28, 29) branchés en aval des multiplexeurs (14, 20 ; 26, 27),
j) et quatre convertisseurs analogique-numérique (16, 22 ; 30, 31), qui sont branchés en aval des circuits d'échantillonnage et de maintien (15, 21 ; 28, 29),
j1) qui sont raccordés par leurs sorties au dispositif d'évaluation (18).

5. Montage selon l'une des revendications précédentes, comportant
k) un processeur de signaux comme dispositif d'évaluation (18).
